# FASCICULE DE BREVET EUROPEEN

(11) **EP 0 517 607 B1**
(45) Date de publication et mention de la délivrance du brevet: **12.03.1997**
(21) Numéro de dépôt: 92401557.1
(22) Date de dépôt: 05.06.1992
(51) Int. Cl.: H01L 21/82, H01L 27/115

(54) **Procédé de fabrication d'une cellule de mémoire non volatile et cellule de mémoire obtenue**
Verfahren zur Herstellung einer nichtflüchtigen Speicherzelle und dadurch hergestellte Speicherzelle
Method of fabrication of a non-volatile memory cell and memory cell fabricated with this method

(30) Priorité: 07.06.1991 FR 9106944
(43) Date de publication de la demande: 09.12.1992
(73) Titulaire: COMMISSARIAT A L'ENERGIE ATOMIQUE, 75015 Paris (FR)
(72) Inventeur: Hartmann, Joel, F-38640 Claix (FR)
(74) Mandataire: Poulin, Gérard

(56) Documents cités:
- EP-A- 0 164 781
- EP-A- 0 164 781
- EP-A- 0 299 853
- DE-A- 4 016 346
- US-A- 4 661 833
- US-A- 4 852 062

## Description

La présente invention a pour objet un procédé de fabrication d'une cellule de mémoire non volatile intégrée à grille flottante ainsi que la cellule obtenue. Plus spécialement, l'invention se rapporte à la fabrication de cellules de mémoire EPROM (mémoire à lecture seule, programmable électriquement) et EEPROM (EPROM effaçable électriquement), ces mémoires pouvant être de type flash ou non.

L'invention s'applique en particulier dans le domaine de la fabrication des circuits mémoires intégrés du type MOS ou du type CMOS.

Une mémoire EPROM ou EEPROM intégrée est un circuit intégré comprenant une partie mémoire proprement dite, appelée cellule de mémoire, formée d'une matrice de plusieurs points mémoires connectés électriquement entre eux et de circuits périphériques servant à commander les points mémoires.

L'invention a trait uniquement à la partie mémoire proprement dite.

L'invention s'adapte à toute génération de règles de dessin. Elle s'applique néanmoins à la réalisation de mémoires non volatiles de grande densité d'intégration, permettant au moins la mémorisation de 10⁶ éléments binaires (≥1 Mbits). . En effet, ce procédé permet de réduire la surface du point mémoire et se rapporte donc principalement à des cellules de mémoires à règles de dessin microniques ou submicroniques, typiquement à des largeurs de grilles flottantes de 0,6µm.

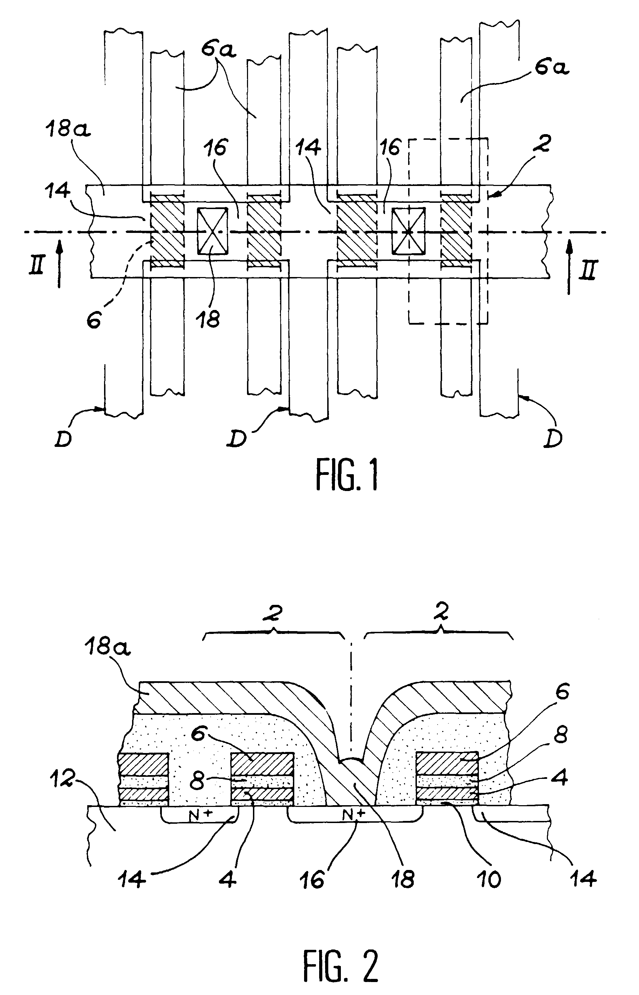

Sur les figures 1 et 2, on a représenté schématiquement une cellule de mémoire EPROM connue réalisée et dessinée dans le concept dit de cellules classiques ou forme en T ; la figure 1 est une vue de dessus et la figure 2 est une coupe longitudinale selon la direction II-II de la figure 1.

Cette cellule comporte, de manière simplifiée, par point mémoire 2, une grille flottante 4 et une grille de commande 6 en silicium polycristallin, empilées et isolées l'une de l'autre par un isolant intergrilles 8, un isolant de grille 10 interposé entre le substrat en silicium 12 et la grille flottante 4, une zone de source 14 diffusée dans le substrat 12, une zone de drain 16 diffusée dans le substrat et un demi-contact électrique 18 métallique. On a référencé D l'ensemble des zones diffusées. Chaque zone de drain 16 est commune à deux points mémoires consécutifs.

Chaque point mémoire est le résultat du croisement d'une ligne de mots 6a formée comme la grille 6 dans la couche supérieure de silicium polycristallin et de la ligne 18a d'éléments binaires, dénommés ci-après bits, réalisée dans la même couche que le demi-contact électrique.

Ce type de point mémoire est utilisé depuis de nombreuses années depuis les générations de quelques kilobits jusqu'aux circuits actuellement les plus avancés de 4 à 16 Mbits.

Son avantage principal réside dans la grande expérience acquise par les fabricants de mémoires EPROM sur ce type de point mémoire et sur la continuité prévisible lorsque l'on passe d'une génération de mémoires à la suivante.

Cependant, avec l'augmentation de la densité d'intégration, il est de plus en plus difficile de faire évoluer ce point mémoire vers les petites dimensions, car les désalignements de niveau à niveau représentent une part considérable de sa surface. Par exemple, les mémoires de 1 Mbits réalisées avec des points mémoires classiques en T ont actuellement une surface d'environ 45mm² pour une surface de point mémoire de 18 à 20µm², et les mémoires de 4 Mbits ont une surface d'environ 70 à 80mm² pour une surface de point mémoire de 9 à 10µm².

De plus, la cellule mémoire classique comporte un demi-contact par point mémoire et pour des densités de plusieurs mégabits, on est amené à réaliser plusieurs millions de contacts dans le circuit ; il se pose alors le problème de la densité de défauts sur ce type de métallisation, nécessitant un contrôle important de cette métallisation et pouvant conduire à des circuits fonctionnant mal par suite d'une mauvaise connexion électrique.

Il y a quelques années, Boaz Eitan de la Société Wafer Scale Integration a proposé un nouveau point mémoire EPROM appelé "Self-aligned Split gate EPROM". Ce point mémoire à grille "fractionnée" est notamment décrit dans le document US-A-4 639 893 du 27 janvier 1987.

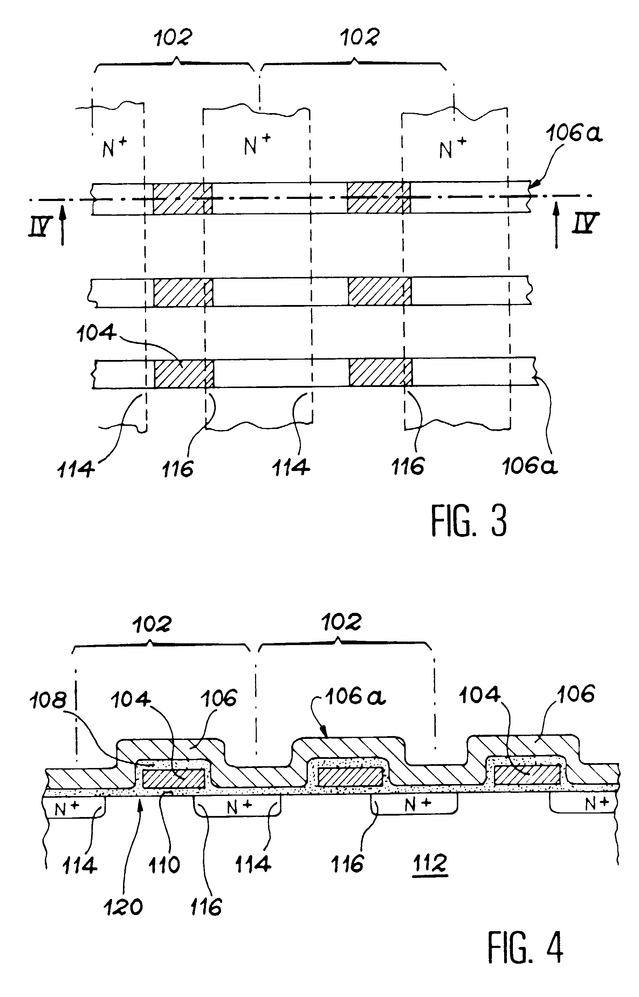

Sur les figures 3 et 4, on a représenté schématiquement une cellule de mémoire EPROM connue à "grille fractionnée" ; la figure 3 est une vue de dessus et la figure 4 est une vue en coupe longitudinale selon la ligne IV-IV de la figure 3.

On retrouve ici, pour chaque point mémoire 102, la grille flottante 104 et la grille de commande 106 isolée par l'isolant intergrilles 108, l'isolant de grille 110, les zones de source 114 et de drain 116 diffusées dans le substrat 112. Les grilles 104 et 106 sont réalisées en silicium polycristallin. Les grilles de commande 106 sont constituées par la partie des lignes de mots 106a en regard des grilles flottantes 104.

Ce point mémoire 102 présente l'avantage d'être formé par le croisement de plots 104 en silicium polycristallin inférieur et des lignes de mots 106a en silicium polycristallin supérieur. En outre, ce point mémoire présente l'avantage de ne pas comporter de contact électrique ; le contact de lignes de bits (c'est-à-dire sur les lignes de drains) est repris seulement tous les 16 ou même 32 points mémoires.

Ce point mémoire à "grille fractionnée" permet ainsi, à règles de dessin identiques à celles des cellules en forme de T, d'obtenir une surface de points mémoires plus petite tout en réduisant considérablement le nombre de contact électrique dans le plan mémoire. Ainsi, la société WSI a récemment annoncé la réalisation, avec ce concept, d'une mémoire EPROM de 1 Mbits d'une surface de 26mm² avec des points mémoires de 9,5µm² de surface, puis une mémoire de 4 Mbits d'une surface de 65mm² réalisée avec les mêmes dimensions de point mémoire.

A cet effet, on peut se référer à l'article VLSI Symposium on Circuits, Kyoto, 1989, de S. All et al. "A new Staggered Virtual Ground array architecture Implemented in a 4Mb CMOS EPROM", pp. 35-36.

De plus, la conception du point mémoire à "grille fractionnée" comprend la réalisation d'un transistor d'accès connecté en série avec la double grille en silicium polycristallin.

Dans la suite de la description, la couche inférieure de silicium polycristallin sera dénommée poly-1 et la couche de silicium polycristallin supérieure sera dénommée poly-2.

Ce transistor d'accès est réalisé par la zone de séparation 120 entre la zone de source 114, généralement de type N⁺, et la grille flottante 104. Cette zone de séparation, contrôlée par la grille en poly-2 de la ligne de mots, module la longueur électrique effective du canal du point mémoire en fonction de la tension appliquée sur le poly-2.

Lorsque la tension de la grille en poly-2 (ou ligne de mots) est nulle, cette zone de canal contrôlée par le poly-2 est bloquée et le point mémoire ne conduit pas. Ceci permet de réduire notablement le courant de fuite des points mémoires d'une même ligne de bits adressée en programmation mais ne se trouvant pas sur la même ligne de mots ; ce courant de fuite est induit par le couplage du drain avec la grille flottante (phénomène de turn-on en terminologie anglo-saxonne).

Ce transistor d'accès permet également d'envisager des largeurs électriques sous la grille flottante plus petites que celles des points mémoires en T, sans risque de perçage entre source et drain des points mémoires. Il permet enfin de réduire la tension de seuil des points mémoires non programmés et donc d'augmenter leur courant de lecture.

Cependant, cette zone de séparation entre source et grille flottante, contrôlée par la ligne de mots, est réalisée dans le brevet de Boaz Eitan, par positionnement d'un masque de résine sur le poly-1. Si ce masquage n'est pas critique dans le cas de largeurs de grille flottante de l'ordre du micromètre, il devient plus difficile, si l'on s'intéresse à des largeurs de grille flottante submicroniques (0,6µm par exemple pour la génération d'une mémoire de 16 Mbits).

Le désalignement de ce masque par rapport aux grilles flottantes a en effet une influence directe sur la largeur de la source de chaque transistor série et sur la longueur électrique (ou canal) du transistor MOS série.

Tous les inconvénients mentionnés ci-dessus existent aussi dans les mémoires EEPROM de type flash ou non qui ne constituent que des EPROM particulières.

Aussi, l'invention a justement pour objet un procédé de fabrication d'une cellule de mémoire non volatile du type sans contact électrique dans chaque point mémoire et à transistors d'accès connectés en série avec les doubles grilles permettant de remédier aux inconvénients ci-dessus. En particulier, ce procédé assure un alignement automatique du transistor série par rapport à la grille flottante du point mémoire associé permettant ainsi d'avoir une longueur de canal de ce transistor série constante ainsi qu'une largeur de source de ce transistor également fixe.

Le principe de l'invention consiste à utiliser pour le décalage entre la source et la grille flottante de chaque point mémoire, un espaceur réalisé sur les flancs de chaque grille flottante, qui possède l'avantage d'avoir une dimension fixe et d'être autoaligné par rapport à la grille flottante.

De façon plus précise, l'invention a pour objet un procédé de fabrication d'une cellule de mémoire non volatile à grille fractionnée sur un substrat semi-conducteur conformément à la revendication 1.

Autrement dit, les lignes de mots et les grilles de commande sont confondues dans les mêmes bandes.

La cellule de mémoire obtenue présente la particularité de ne pas posséder de contact électrique dans le point mémoire unitaire et d'avoir un transistor d'accès connecté en série avec l'empilement de grilles ; ce transistor est auto-aligné par rapport à la grille flottante de chaque point mémoire et ses dimensions sont fixes.

En utilisant une largeur et une longueur de grille flottante de 0,6µm chacune, il est possible d'atteindre avec le procédé de l'invention une surface de point mémoire de 1,96µm² alors que les plus petites tailles de point mémoire aujourd'hui publiées avec ces règles de dessin pour des cellules en T sont de l'ordre de 3,5 à 4µm, ce qui correspond à un gain proche de 2 en densité d'intégration.

Selon l'invention, il est possible d'utiliser des grilles de commande et des lignes de mots en métal (Al, W, Ta, Mo), en un siliciure d'un métal réfractaire (TiSi₂, TaSi₂, WSi₂, PtSi) ou en silicium polycristallin dopé au phosphore (0,5 à 2% en poids).

Lorsque les grilles flottantes sont réalisées en silicium polycristallin dopé au phosphore et que le substrat est réalisé en silicium monocristallin, la couche mince d'isolant électrique formée au cours de l'étape 7) est avantageusement obtenue par oxydation thermique du silicium mono et polycristallin. Dans ce cas, l'oxydation thermique du silicium polycristallin destiné à la fabrication des grilles flottantes permet la réalisation des isolants intergrilles.

Il est possible de remplacer cette étape d'oxydation thermique par le dépôt d'un ou plusieurs isolants électriques tel que de l'oxynitrure de silicium, du nitrure de silicium ou de l'oxyde de silicium.

Lorsque l'on désire réaliser les isolants intergrilles autrement que par oxydation thermique du silicium polycristallin des grilles flottantes, il est préférable de protéger ces isolants intergrilles pendant toutes les étapes ultérieures du procédé de fabrication.

Aussi, dans un mode préféré de mise en oeuvre, le procédé selon l'invention de fabrication d'une cellule de mémoire, comporte les étapes de la revendication 3.

Ici, les lignes de mots et les grilles de commande sont distinctes et réalisées par exemple en deux matériaux conducteurs différents.

Dans ce mode de réalisation, les isolants intergrilles (c'est-à-dire la seconde couche d'isolant) peuvent être réalisés en n'importe quel type de matériau isolant et en particulier par un empilement tricouche d'oxyde de silicium, de nitrure de silicium et d'oxyde de silicium, noté généralement ONO.

De plus, dans ce mode de réalisation, la seconde couche conductrice peut être réalisée en un des siliciures cités précédemment ou en silicium polycristallin dopé au phosphore de 0,5 à 2% en poids.

Afin d'utiliser cette couche conductrice pour assurer le contact électrique avec la ligne de mots de chaque point mémoire, il est nécessaire de protéger contre l'oxydation thermique cette seconde couche conductrice par une couche de protection (voir étape i)). Cette couche protectrice peut être réalisée par exemple en nitrure de silicium.

La couche de protection permet en outre une gravure des bandes d'espacement puis une réoxydation des zones de source et de drain sans modifier la structure de l'isolant intergrilles et en particulier de l'empilement ONO.

Les bandes d'espacement peuvent être réalisées en n'importe quel matériau isolant électrique comme le nitrure de silicium, l'oxynitrure de silicium ou l'oxyde de silicium, ou encore en silicium polycristallin non dopé, la seule contrainte de ces bandes d'espacement étant leur aptitude à être gravées sélectivement par rapport aux matériaux sous-jacents (en particulier par rapport au matériau destiné aux grilles flottantes des points mémoires, la couche de protection et au substrat).

De même, les isolants de grille peuvent être réalisés par exemple en oxyde de silicium ou un oxynitrure de silicium.

Afin de diminuer la résistance d'accès des lignes de mots, il est possible, lorsque ces lignes de mots sont réalisées en silicium polycristallin dopé, de les recouvrir d'une couche de siliciure d'un matériau réfractaire tel que ceux cités précédemment.

D'autres caractéristiques et avantages de l'invention ressortiront mieux de la description qui va suivre, donnée à titre illustratif et non limitatif.

La description se réfère aux dessins annexés dans lesquels :
- les figures 1 et 2, déjà décrites, représentent schématiquement une cellule de mémoire EPROM en forme de T selon l'art antérieur ;
- les figures 3 et 4, déjà décrites, représentent schématiquement une cellule de mémoire connue à "grille fractionnée" ;
- les figures 5 à 12 représentent schématiquement les différentes étapes du procédé conforme à l'invention, les figures 5 à 11 étant des coupes longitudinales et la figure 12 une vue de dessus ; et
- les figures 13 à 15 représentent schématiquement, en coupe longitudinale, une variante du procédé conforme à l'invention.

La description ci-après se réfère à la fabrication d'une cellule mémoire EPROM de façon à simplifier cette description. Toutefois, comme on l'a vu précédemment, l'invention est d'application beaucoup plus générale puisqu'elle s'applique à tous les types de cellules mémoires non volatiles.

Le procédé ci-dessous est décrit après la réalisation des caissons N et P, de l'isolation de champ, du dopage sous l'isolant de champ pour isoler des zones actives, de l'oxydation sacrificielle ainsi que du dopage du substrat semi-conducteur des points mémoires pour ajustement de la tension de seuil de ces points mémoires. Ces éléments sont réalisés comme dans l'art antérieur.

Enfin, la description ci-après est faite pour un substrat monocristallin de silicium de type P. Ce substrat porte la référence 212.

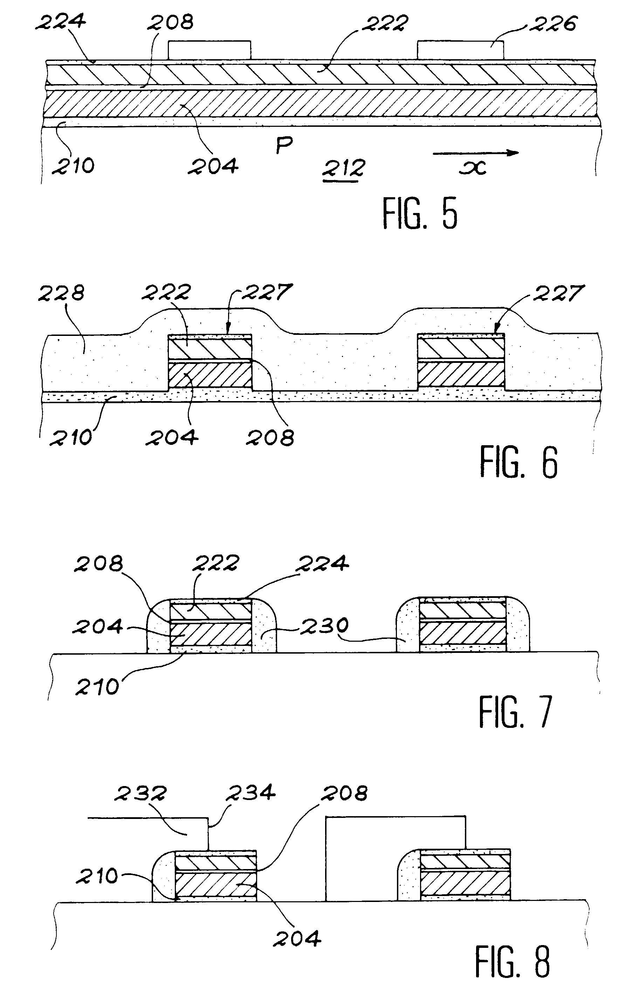

On procède alors, comme représenté sur la figure 5, à la réalisation, dans le plan mémoire, d'une oxydation thermique 210 du silicium 212 sur une épaisseur par exemple de 20nm à une température de 1000°C sous oxygène sec. Cette oxydation thermique servira à la réalisation des isolants de grilles.

Puis on effectue un dépôt de silicium polycristallin 204 inférieur (poly-1) par dépôt chimique en phase vapeur basse pression (LPCVD) à 620°C d'une épaisseur de 150nm. Ce dépôt 204 servira à la réalisation de la grille flottante des points mémoires.

Ce silicium polycristallin 204 est ensuite dopé par diffusion de phosphore (0,5 à 2% en poids) dans un four à 950°C.

On procède ensuite au dépôt d'un matériau isolant 208 dans lequel sera réalisé les isolants intergrilles. Ce dépôt consiste successivement en une oxydation thermique du silicium polycristallin 204, en un dépôt LPCVD d'une fine couche de nitrure (mélange NH₃ et SiH₂Cl₂) à 800°C puis en une légère réoxydation thermique de ce nitrure, pour obtenir une épaisseur équivalente en SiO₂ de ce tricouche de 20nm.

On dépose alors une couche 222 de silicium polycristallin de 150nm par dépôt LPCVD à 620°C. Le dopage de ce silicium (0,5 à 2% en poids) est aussi réalisé par diffusion de phosphore dans un four à 950°C.

On dépose enfin sur cette couche 222 de silicium polycristallin, une fine couche de nitrure de silicium 224 par LPCVD à 800°C, d'une épaisseur de 50nm. Cette couche servira à éviter une réoxydation de la couche sous-jacente 222 de silicium pendant la réoxydation de source et de drain et permettra ainsi un bon contact électrique entre ce silicium polycristallin et le bicouche (siliciure+poly-2) des lignes de mots.

Après empilement de toutes ces couches, on procède au masquage 226 du premier niveau de silicium (poly-1) par photolithographie en photorépétition directe sur tranche, bien connue de l'homme de l'art. Ce masque fixe la dimension des grilles flottantes selon la direction x des canaux et masque les zones de poly-1 à conserver. Il se présente sous forme de bandes perpendiculaires à la direction x.

La gravure de l'empilement des couches 204, 208, 222 et 224 est ensuite réalisée par gravure sèche, par exemple par gravure ionique réactive en utilisant de l'hexafluorure de soufre SF₆ et en s'arrêtant dans l'oxyde de grille 210. La résine de masquage 226 est ensuite éliminée sous vide, par plasma d'oxygène. La structure obtenue est représentée sur la figure 6.

On obtient des bandes 227 de l'empilement des couches 204, 208, 222 et 224, perpendiculaires à direction x dont la largeur est égale à la longueur des grilles flottantes à réaliser.

On procède alors à la réalisation des bandes d'espacement ou espaceurs. Ces espaceurs peuvent être soit en oxyde de silicium, soit en nitrure de silicium, soit en silicium polycristalliin. On décrit ici un exemple de réalisation utilisant des espaceurs en oxyde de silicium.

Après dépôt par LPCVD à 800°C d'une couche 228 d'oxyde de silicium, à partir de tétraéthoxysilane (TEOS), sur une épaisseur de 400nm (figure 6), on procède à une gravure anisotrope de cet oxyde par gravure plasma, gaz CHF₃, de manière à réaliser, comme représenté sur la figure 7, des espaceurs 230 d'oxyde d'une largeur de 200 nm sur les flancs des bandes 227 (sur toute la longueur des bandes).

L'élimination des espaceurs du côté des drains des points mémoires à réaliser est ensuite effectuée à l'aide d'un masque photolithographique 232, aligné sur l'empilement de couches et en particulier sur le poly-1 204, puis d'une gravure chimique avec une solution de FH-FNH₄. La structure obtenue est représentée sur la figure 8. (Le masque 232 comporte des ouvertures 234 en regard des régions du substrat destinées aux drains et d'une partie de chaque bande 204 de poly-1).

Après élimination de ce masque de résine par un plasma d'oxygène, on procède à l'implantation ionique N⁺ des points mémoires, par exemple d'arsenic à une énergie de 70 KeV et une dose de 3x10⁵at.cm².

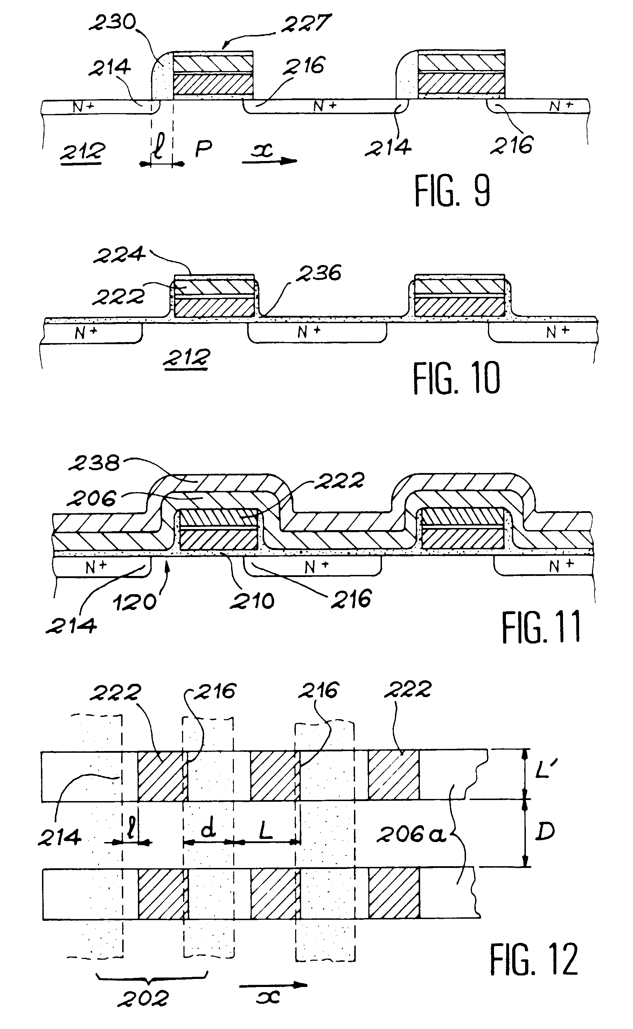

La structure obtenue est celle représentée sur la figure 9.

Grâce à l'implantation d'ions N⁺ en utilisant les bandes 227 de couches gravées et les espaceurs 230 restants comme masque d'implantation, on obtient des bandes diffusées dans le substrat 212 parallèles entre elles et perpendiculaires à la direction x du canal des points mémoires. Les zones diffusées se trouvent décalées du côté source 214, d'une distance l constante, de chaque bande 227 alors qu'elles se trouvent alignées automatiquement par rapport à ces bandes 227 du côté du drain 216 des points mémoires.

On obtient ainsi un auto-alignement des drains par rapport aux grilles flottantes et un décalage l des sources par rapport à ces grilles.

On élimine alors complètement les espaceurs 230 restants du côté source par une gravure chimique en utilisant une solution de FH-FNH₄.

On réalise ensuite le recuit de cette implantation ionique par exemple à 850°C pendant 30 minutes afin de faire diffuser les ions implantés et de les activer électriquement. La structure obtenue est celle représentée sur la figure 10.

On effectue alors une réoxydation 236 des zones de source et de drain par oxydation thermique du silicium 212 sur une épaisseur de 20nm à 1000°C sous oxygène sec.

Pendant cette réoxydation, la couche de nitrure 224 de chaque point mémoire empêche toute oxydation thermique de la couche de silicium polycristallin sous-jacente 222. On élimine ensuite cette couche de nitrure de silicium par gravure chimique à l'aide d'un bain d'acide orthophosphorique à 150°C. La structure obtenue est représentée sur la figure 11.

On procède alors au dépôt de la couche supérieure de silicium polycristallin 206 constituant le niveau de poly-2 par LPCVD à 620°C sur une épaisseur de 250nm. Cette couche 206 de silicium est ensuite dopée par diffusion de phosphore en four à 950°C à une concentration de 0,5 à 2% en poids. On dépose enfin avantageusement une couche de siliciure de tungstène 238 par LPCVD à 400°C sur une épaisseur de 200 nm.

La couche 206 de poly-2 est en contact avec la couche de silicium 222 gravée et assure ainsi le contact électrique avec les lignes de mots.

Le procédé de l'invention se poursuit ensuite par le masquage de la structure par un masque constitué de bandes parallèles à la direction x puis par la gravure des couches 206 et 238 sous forme de bandes 206a, comme représenté sur la figure 12, constituant les lignes de mots. Ces bandes 206a sont perpendiculaires aux bandes 214 et 216 diffusées et donc parallèles à la direction x.

On effectue ensuite une gravure des bandes 227 en s'arrêtant sur le substrat, en utilisant le masque de gravure des lignes de mots 206a comme masque, afin d'obtenir les dimensions finales des grilles flottantes, des isolants intergrilles, des isolants de grilles et des grilles de commande constitués ici par des plots conducteurs 222. Le masque de gravure est ensuite éliminé.

Conformément à l'art antérieur, on réalise alors les transistors périphériques N et P de la mémoire, le dépôt puis le fluage d'une couche d'isolant électrique sur l'ensemble du circuit intégré, l'ouverture de trous de contact dans cet isolant en regard des zones diffusées 214 et 216 notamment, la métallisation des lignes de bits et enfin la passivation de l'ensemble du circuit à l'aide d'un isolant électrique.

Avec le procédé de l'invention, il est possible, en utilisant des règles de dessin de 0,6 µm, de réaliser des points mémoires 202 de surface inférieure à 2µm² alors que les plus petites tailles de points mémoire aujourd'hui publiées sont de l'ordre de 3,5 à 4µm².

Il est ainsi possible de réaliser des points mémoires de 1,96 à 2,5µm² de surface avec une largeur L' et une longueur L respectivement de grille flottante de 0,6µm ; une distance D séparant deux lignes de mots 206a de 0,8µm ; une largeur L' des lignes de mots 206a de 0,6µm ; une distance d séparant deux grilles flottantes de 0,8µm.

Avec des règles de dessin de 0,4 µm (L=L'=0,4µm), on peut obtenir des points mémoires de 1 à 1,5µm² de surface.

Ainsi, la distance l (fixée par la largeur des espaceurs) est de 0,2µm, ce qui correspond au décalage entre la source et l'empilement de grilles d'un point mémoire. Cette zone de séparation définit le transistor MOS d'accès, connecté en série avec les grilles. Il porte la référence 120 sur la figure 11. La longueur de son canal est égale à l.

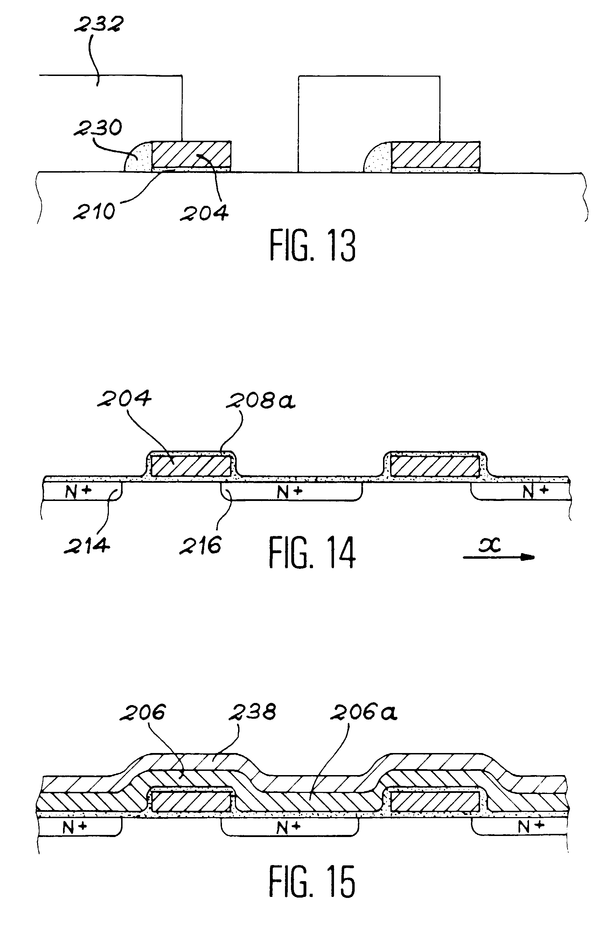

Sur les figures 13 à 15, on a représenté une variante du procédé conforme à l'invention. Dans cette variante, l'isolant intergrilles est réalisé au cours de la réoxydation des sources et drains des points mémoires. Il n'est donc plus nécessaire d'utiliser la couche de silicium polycristallin 222, ni la couche de nitrure 224.

Aussi, comme représenté sur la figure 13, après le dépôt de la couche d'isolant de grille 210, puis de la couche de silicium poly-1 204, on effectue une gravure de cet empilement pour fixer la longueur de la grille flottante. On dépose ensuite sur l'ensemble de la structure une couche d'oxyde de silicium destinée à former les espaceurs, de 400 nm d'épaisseur, puis on effectue une gravure de cette couche pour former les espaceurs 230.

Après formation du masque lithographique 232 permettant l'auto-alignement des drains par rapport à la grille flottante 204 et le décalage des sources, on élimine les espaceurs du côté drain puis le masque de résine 232 ayant servi à cette élimination. La structure obtenue est représentée sur la figure 14.

Après l'implantation N⁺, comme décrit précédemment, on élimine les espaceurs restants du côté source, puis on effectue la réoxydation des sources et drains des points mémoires ainsi que l'oxydation des grilles flottantes 204, on obtient ainsi un isolant intergrilles 208a en oxyde de silicium de 20 nm d'épaisseur.

Le procédé se poursuit, comme représenté sur la figure 15, par le dépôt de la couche 206 de silicium polycrystallin (poly-2) et de la couche de siliciure 238. Le reste du procédé est inchangé.

## Revendications

1. Procédé de fabrication d'une cellule de mémoire non volatile à grille fractionnée sur un substrat semi-conducteur (212) d'un type donné de conductivité, comportant :
a) - une matrice de points mémoires (202) isolés électriquement les uns des autres et pourvus chacun d'un empilement d'une grille flottante (204) et d'une grille de commande (206) isolées électriquement l'une de l'autre, d'un isolant de grille (208) intercalé entre la grille flottante et le substrat, d'une source (214) et d'un drain (216) formés dans le substrat de part et d'autre de l'empilement, d'un canal situé sous la grille flottante, ayant une longueur orientée selon une direction (x) allant de la source au drain, et d'un transistor d'accès (120) formé entre la source et l'empilement et relié en série avec chaque point mémoire,
b) - des lignes de mots (206a) constituées de bandes conductrices parallèles à cette direction, formant la grille de commande de chaque point mémoire, et du transistor d'accès, ce procédé comprenant les étapes suivantes :
1) réalisation sur le substrat d'un empilement d'une couche d'isolant électrique (210) et d'une couche conductrice (204) destinée respectivement à former les isolants de grilles (210) et les grilles flottantes (204),
2) gravure de cet empilement de couches (210, 204) pour former des bandes dudit empilement perpendiculaires à ladite direction (x),
3) réalisation de bandes d'espacement (230) autoalignées sur les flancs des bandes dudit empilement par dépôt d'un matériau apte à être gravé sélectivement par rapport à la couche conductrice de l'empilement et au substrat, puis par gravure anisotrope de ce matériau,
4) élimination des bandes d'espacement (230) du côté des drains (216) à réaliser,
5) implantation d'ions d'un type de conductivité différent de celui du substrat en utilisant les bandes d'espacement restantes et les bandes dudit empilement comme masque pour former les sources (214) et drains (216) des transistors, respectivement déplacées et alignés par rapport aux bandes dudit empilement,
6) élimination des bandes d'espacement (230) restantes,
7) formation d'une couche mince d'isolant électrique (208a) sur les sources et drains des transistors et sur les bandes dudit empilement,
8) réalisation de bandes conductrices (206a) sur les bandes dudit empilement, ces bandes conductrices étant parallèles à ladite direction et formant ainsi les grilles de commande et les lignes de mots, et
9) gravure des bandes dudit empilement en utilisant lesdites bandes conductrices comme masque, pour fixer les dimensions des grilles flottantes et des isolants de grilles.

2. Procédé selon la revendication 1, caractérisé en ce que le substrat et les grilles flottantes sont en silicium et en ce que la couche mince d'isolant est obtenue par oxydation du silicium.

3. Procédé de fabrication d'une cellule de mémoire non volatile à grille fractionnée sur un substrat semi-conducteur d'un type donné de conductivité, comportant :
a) - une matrice de points mémoires (202) isolées électriquement les uns des autres et pourvus chacun d'un empilement d'une grille flottante (204) et d'une grille de commande (206) isolées électriquement l'une de l'autre, d'un isolant de grille (208) intercalé entre la grille flottante et le substrat, d'une source (214) et d'un drain (216) formés dans le substrat de part et d'autre de l'empilement, d'un canal situé sous la grille flottante, ayant une longueur orientée selon une direction (x) allant de la source au drain, et d'un transistor d'accès (120) formé entre la source et l'empilement et relié en série avec chaque point mémoire.
b) - des lignes de mots (206a) constituées de bandes conductrices parallèles à cette direction, les lignes de mots passant au-dessus et étant en contact avec les grilles de commande, et formant les grilles des transistors d'accès, ce procédé comprenant les étapes suivantes :
i) - réalisation sur le substrat d'un empilement d'une première couche d'isolant électrique (210) destinée à former les isolants de grilles, d'une première couche conductrice (204) destinée à former les grilles flottantes (204), d'une seconde couche au moins d'isolant électrique (208) destinée à former les isolants intergrilles (208), d'une seconde couche conductrice (222) destinée à réaliser les grilles de commande (206) et d'une couche de protection (224) que l'on peut graver sélectivement par rapport à la seconde couche conductrice,
ii) - gravure de cet empilement de couches pour former des bandes (227) dudit empilement perpendiculaires à ladite direction x),
iii) - réalisation de bandes d'espacement (230) autoalignées sur les flancs des bandes dudit empilement, ces bandes étant réalisées par dépôt d'un matériau apte à être gravé sélectivement par rapport à la couche de protection et au substrat, puis par gravure anisotrope de ce matériau,
iv) - élimination des bandes d'espacement du côté des drains (216) à réaliser,
v) - implantation d'ions d'un type de conductivité différent de celui du substrat en utilisant les bandes d'espacement restantes et les bandes dudit empilement de couches comme masque pour former les sources (214) et drains (216) des transistors, respectivement déplacées et alignés par rapport aux bandes dudit empilement,
vi) - élimination des bandes d'espacement restantes,
vii) - formation d'une couche mince d'isolant électrique (236) sur les sources et drains des transistors,
viii) - élimination de la couche de protection,
ix) - réalisation de bandes conductrices (206a) sur les bandes dudit empilement obtenues en viii), ces bandes conductrices étant parallèles à ladite direction et formant ainsi les lignes de mots, et
x) - gravure des bandes dudit empilement obtenues en viii) en utilisant lesdites bandes conductrices comme masque, pour fixer les dimensions des grilles de commande, des isolants intergrilles, des grilles flottantes et des isolants de grille.

4. Procédé selon la revendication 3, caractérisé en ce que l'isolant intergrille est un matériau tricouche d'oxyde, de nitrure et d'oxyde de silicium.

5. Procédé selon la revendication 3 ou 4, caractérisé en ce que la seconde couche conductrice est réalisée en silicium polycristallin dopé.

6. Procédé selon la revendication 5, caractérisé en ce que la couche de protection est réalisée en nitrure de silicium.

7. Procédé selon l'une quelconque des revendications 1 à 6, caractérisé en ce que les bandes conductrices sont réalisées en un matériau bicouche.

8. Procédé selon l'une quelconque des revendications 1 à 7, caractérisé en ce que l'on effectue un recuit après l'implantation d'ions pour faire diffuser ces ions dans le substrat et les activer.

## Patentansprüche

1. Verfahren zur Herstellung einer nichtflüchtigen Speicherzelle mit geteiltem Gate auf einem Halbleitersubstrat (212) eines bestimmten Konduktivitätstyps, umfassend:
a) - eine Matrix von Speicherpunkten (202), elektrisch voneinander isoliert und jeder versehen mit einer Aufschichtung bzw. einem Stapel aus einem schwebenden Gate (204) und einem Steuergate (206), elektrisch voneinander isoliert, einem Gate-Isolator (208), eingefügt zwischen das schwebende Gate und das Substrat, einer Source (214) und einem Drain (216), gebildet in dem Substrat beiderseits des Stapels, einem Kanal, unter dem schwebenden Gate befindlich, mit einer entsprechend einer Richtung (x) orientierten Länge, die sich von der Quelle zum Drain erstreckt, und einem Zugriff-Transistor (120), gebildet zwischen der Source und dem Stapel und in Serie verbunden mit jedem Speicherpunkt,
b) - Wörterzeilen (206a), gebildet durch zu dieser Richtung parallele leitende Streifen, das Steuergate jedes Speicherpunkts bildend, und des Zugriff-Transistors, wobei dieses Verfahren die folgenden Schritte umfaßt:
1) Herstellung einer Aufschichtung aus einer elektrisch isolierenden Schicht (210) und einer leitenden Schicht (204) auf dem Substrat, dazu bestimmt, jeweils die Gate-Isolatoren (210) und die schwebenden Gates (204) zu bilden,
2) Ätzung dieser Aufschichtung (210, 204), um daraus Streifen senkrecht zu der genannten Richtung (x) zu bilden,
3) Herstellung von selbstausrichtenden Abstandsstreifen (230) an den Flanken der Streifen der besagten Aufschichtung durch Abscheiden eines Materials, das in bezug auf die leitende Stapelschicht und das Substrat selektiv geätzt werden kann, danach durch anisotrope Ätzung dieses Materials,
4) Beseitigung der Abstandsstreifen (230) auf der Seite der herzustellenden Drains (216),
5) Implantation von Ionen eines sich von dem des Substrats unterscheidenden Konduktivitätstyps, wobei die noch vorhandenen Abstandsstreifen und die Streifen der besagten Aufschichtung als Maske benutzt werden, um die Sources (214) und Drains (216) der Transistoren zu bilden, jeweils versetzt und ausgerichtet in bezug auf die Streifen der besagten Aufschichtung,
6) Beseitigung der noch vorhandenen Abstandsstreifen (230),
7) Bildung einer dünnen Schicht eines elektrischen Isolators (208a) auf den Sources und Drains der Transistoren und auf den Streifen der besagten Aufschichtung,
8) Herstellung von leitenden Streifen (206a) auf den Streifen der besagten Aufschichtung, wobei diese leitenden Streifen parallel sind zu der genannten Richtung und so die Steuergates und die Wörterzeilen bilden, und
9) Ätzung der Streifen der besagten Aufschichtung, wobei die genannten leitenden Streifen als Maske benutzt werden, um die Abmessungen der schwebenden Gates und der Gate-Isolatoren festzulegen.

2. Verfahren nach Anspruch 1, dadurch gekennzeichnet, daß das Substrat und die schwebenden Gates aus Silicium sind, und dadurch, daß die dünne Isolatorschicht durch Oxidation des Siliciums erzeugt wird.

3. Verfahren zur Herstellung einer nichtflüchtigen Speicherzelle mit geteiltem Gate auf einem Halbleitersubstrat eines bestimmten Konduktivitätstyps, umfassend:
a) - eine Matrix von Speicherpunkten (202), elektrisch voneinander isoliert und jeder versehen mit einem Stapel aus einem schwebenden Gate (204) und einem Steuergate (206), elektrisch voneinander isoliert, einem Gate-Isolator (208), eingefügt zwischen das schwebende Gate und das Substrat, einer Source (214) und einem Drain (216), gebildet in dem Substrat beiderseits des Stapels, einem Kanal, unter dem schwebenden Gate befindlich, mit einer entsprechend einer Richtung (x) orientierten Länge, die sich von der Quelle zum Drain erstreckt, und einem Zugriff-Transistor (120), gebildet zwischen der Source und dem Stapel und in Serie verbunden mit jedem Speicherpunkt,
b) - Wörterzeilen (206a), gebildet durch zu dieser Richtung parallele leitende Streifen, wobei die Wörterzeilen die Steuergates überqueren und mit ihnen Kontakt haben und die Gates der Zugriff-Transistoren bilden und dabei dieses Verfahren die folgenden Schritte umfaßt:
i) Herstellen einer Aufschichtung aus einer ersten elektrisch isolierenden Schicht (210), um die Gate-Isolatoren zu bilden, einer ersten leitenden Schicht (204), um die schwebenden Gates (204) zu bilden, wenigstens einer zweiten elektrisch isolierenden Schicht (208), um die Intergate-Isolatoren (208) zu bilden, einer zweiten leitende Schicht (222), um die Steuergates (206) zu bilden, und einer Schutzschicht (224), die man in bezug auf die zweite leitende Schicht selektiv ätzen kann,
ii) Ätzen dieses Schichtenstapels, um daraus Streifen (227) zu bilden, die senkrecht sind zu der genannten Richtung (x),
iii) Herstellen von selbstausrichtenden Abstandsstreifen (230) an den Flanken der Streifen der besagten Aufschichtung, wobei diese Streifen erzeugt werden durch Abscheiden eines Materials, das sich eignet, in bezug auf die Schutzschicht und das Substrat selektiv geätzt zu werden,
iv) Beseitigung der Abstandsstreifen auf der Seite der herzustellenden Drains (216),
v) Implantation von Ionen eines sich von dem des Substrats unterscheidenden Konduktivitätstyps, wobei die noch vorhandenen Abstandsstreifen und die Streifen der besagten Aufschichtung als Maske benutzt werden, um die Sources (214) und Drains (216) der Transistoren zu bilden, jeweils versetzt und ausgerichtet in bezug auf die Streifen der besagten Aufschichtung,
vi) Beseitigung der noch vorhandenen Abstandsstreifen,
vii) Bildung einer dünnen Schicht eines elektrischen Isolators (236) auf den Sources und Drains der Transistoren,
viii) Beseitigung der Schutzschicht,
ix) Herstellung von leitenden Streifen (206a) auf den Streifen der in (viii) erhaltenen Aufschichtung, wobei diese leitenden Streifen parallel zu der genannten Richtung sind und so die Wörterzeilen bilden, und
x) Ätzung der Streifen der in (viii) erhaltenen Aufschichtung, wobei die genannten leitenden Streifen als Maske benutzt werden, um die Abmessungen der Steuergates, der Intergate-Isolatoren, der schwebenden Gates und der Gate-Isolatoren festzulegen.

4. Verfahren nach Anspruch 3, dadurch gekennzeichnet, daß der Intergate-Isolator ein dreischichtiges Material aus Siliciumoxid, Siliciumnitrid und Siliciumoxid ist.

5. Verfahren nach Anspruch 3 oder 4, dadurch gekennzeichnet, daß die zweite leitende Schicht aus dotiertem polykristallinem Silicium hergestellt wird.

6. Verfahren nach Anspruch 5, dadurch gekennzeichnet, daß die Schutzschicht aus Siliciumnitrid hergestellt wird.

7. Verfahren nach einem der Ansprüche 1 bis 6, dadurch gekennzeichnet, daß die leitenden Streifen aus einem zweischichtigen Material hergestellt werden.

8. Verfahren nach einem der Ansprüche 1 bis 7, dadurch gekennzeichnet, daß man nach der Ionenimplantation ein Tempern durchführt, um diese Ionen im Substrat zu diffundieren und sie zu aktivieren.

## Claims

1. Method for producing a non-volatile memory cell on a semiconductive substrate (212) with a given type of conductivity and comprising:
a) a matrix of memory points (202) electrically isolated from one another and each provided with a stacking of one floating gate (204) and one control gate (206), both gates electrically isolated from each other, one gate nonconductor (208) inserted between the floating gate and the substrate, one source (214) and one drain (216) both formed in the substrate on both sides of the stacking, one channel situated under the floating gate and having a length orientated along a direction (x) extending from the source to the drain, and one access transistor (120) formed between source and stack connected in series to the stacking of gates,
b) lines of words (206a) constituted by conductive strips parallel to this direction,
this method including the following stages:
1) embodying on the substrate a stacking of one electric nonconductive film (210) and one conductive film (204) respectively intended to form the gate nonconductors (210) and the floating gates (204),
2) etching of this stacking of films (210, 204) so as to form the strips of said stacking, said strips being perpendicular to said direction (x),
3) embodying of spacing strips (230) on the flanks of the strips of said stacking made of a material able to be selectively etched with respect to the conductive film of the stacking and to the substrate,
4) elimination of the spacing strips (230) on the side of the drains (216) to be embodied,
5) implantation of ions with a type of conductivity differing from that of the substrate by using the remaining spacing strips and the strips of said stacking as a mask so as to form the sources (214) and drains (216) of the transistors, respectively offset and aligned with respect to the strips of said stacking,
6) elimination of the remaining spacing strips (230),
7) formation of a thin electric nonconductive film (208a) on the sources and drains of the transistors and on the strips of said stacking,
8) embodying of conductive strips (206a) on the strips of said stacking, these conductive strips being parallel to said direction and thus forming the control gates and the lines of words, and
9) etching of the strips of said stacking by using said conductive strips as a mask so as to fix the dimensions of the floating gates and the gate nonconductors.

2. Method according to claim 1, characterized in that the substrate and the floating gates are made of silicon and wherein the thin nonconducting film is obtained by oxidizing the silicon.

3. Method for producing a non-volatile memory cell on a semiconductive substrate with a given type of conductivity and comprising:
a) a matrix of memory points (202) electrically isolated from one another and each provided with a stacking of one floating gate (204) and one control gate (206), both gates electrically isolated from each other, one gate nonconductor (208) inserted between the floating gate and the substrate, one source (214) and one drain (216), both formed in the substrate on both sides of the stacking, one channel situated under the floating gate and having a length orientated along a direction (x) extending from the source to the drain, and one access transistor (120) formed between the source and the stack, connected in series with each memory point,
b) lines of words (206a) constituted by conductive strips parallel to this direction, the lines of words passing above and being in contact with the control gates and forming the gates of the access transistors, this method including the following stages:
i) embodying on the substrate a stacking of one first electric nonconducting film (210) intended to form the gate nonconductors, one first conductive film (204) intended to form the floating gates (204), at least one second electric nonconducting film (208) intended to form the inter-gate nonconductors (208), one second conductive film (222) intended to embody the control gates (206) and one protection film (224) able to be selectively etched with respect to the second conductive film,
ii) etching of this stacking of films so as to form the strips (227) of said stacking, said strips being perpendicular to said direction (x),
iii) embodying of spacing strips (230) on the flanks of the strips of said stacking, these strips being made of a material able to be selectively etched with respect to the protection film and to the substrate,
iv) elimination of the spacing strips on the side of the drains (216) to be embodied,
v) implantation of ions with a type of conductivity differing from that of the substrate by using the remaining spacing strips and the strips of the stacking of films as a mask so as to form the sources (214) and drains (216) of the transistors respectively displaced and aligned with respect to the strips of said stacking,
vi) elimination of the remaining spacing strips,
vii) formation of a thin electric nonconducting film (236) on the sources and drains of the transistors,
viii) elimination of the protection film,
ix) embodying of conductive strips (206a) on the strips of said stacking obtained at viii), these conductive strips being parallel to said direction and thus forming the lines of words, and
x) etching of the strips of said stacking obtained at viii) by using said conductive strips as a mask so as to fix the dimensions of the control gates, the inter-gate nonconductors, the floating gates and of the gate nonconductors.

4. Method according to claim 3, characterized in that the inter-gate nonconductor is made of a silicon oxide, silicon nitride and silicon oxide trifilm material.

5. Method according to claim 3 or 4, characterized in that the second conductive film is composed of doped polycrystalline silicon.

6. Method according to claim 5, characterized in that the protection film is composed on silicon nitride.

7. Method according to any one of the claims 1 to 6, characterized in that the conductive strips are made of a bifilm material.

8. Method according to any one of the claims 1 to 7, characterized in that an annealing is carried out after the implantation of ions so as to make these ions diffuse inside the substrate and activate them.
